# EUROPEAN PATENT APPLICATION

(11) **EP 4 757 532 A1**
(43) Date of publication of application: **10.06.2026**
(21) Application number: 25220832.7
(22) Date of filing: 04.12.2025
(51) Int. Cl.: H10D 30/63, H10D 62/85, H10D 64/27

(54) **VERTICAL GALLIUM NITRIDE TRANSISTORS**

(30) Priority: 06.12.2024 US 202463728947 P; 20.11.2025 US 202519395957
(71) Applicant: Power Integrations, Inc., San Jose, CA 95138 (US)
(72) Inventor: Georgescu, Sorin S., Gilroy, 95020 (US); Yang, Kuo-Chang Robert, Campbell, 95008 (US)
(74) Representative: Fish & Richardson P.C.

(57) **Abstract**

Vertical gallium nitride (GaN) field effect transistors (FETs) are presented herein. A vertical GaN FET includes cylindrical trench gates arranged in a hexagonal array to form vertical FET channels. At the surface of the vertical GaN FET is a source layer formed in a GaN epitaxial layer and over a GaN substrate. A channel may be formed between the cylindrical gates in the form of a "GaN pillar"; and FET characteristics, including threshold voltage, may be determined, at least in part by a trench nearest neighbor distance. Accordingly, the trench nearest neighbor distance may be selected so that the vertical GaN FET operates as either an enhancement mode or a depletion mode transistor.

## Description

### CROSS-REFERENCE TO RELATED APPLICATIONS

This application claims priority from U.S. Provisional Application No. 63/728,947, filed on December 6, 2024, and from U.S. Non-Provisional Application No. 19/395,957, filed on November 20, 2025, hereby incorporated by reference in their entirety.

### FIELD OF THE DISCLOSURE

The present invention relates to vertical power semiconductor devices and more particularly to gallium nitride (GaN) power semiconductor devices.

### BACKGROUND INFORMATION

Gallium nitride (GaN) and other wide band-gap nitride III based direct transitional semiconductor materials exhibit high break-down electric fields and avail high current densities. In this regard GaN based semiconductor devices are actively researched as an alternative to silicon based semiconductor devices in power and high frequency applications. For instance, a GaN power device may provide lower specific on resistance with higher breakdown voltage relative to a silicon power field effect transistor of commensurate area.

Field effect transistors (FETs), including power FETs, can be enhancement mode or depletion mode. An enhancement mode device may refer to a transistor (e.g., a field effect transistor) which blocks current *(i.e.,* which is off) when there is no applied gate bias *(i.e.,* when the gate to source bias is zero). In contrast, a depletion mode device may refer to a transistor which allows current (i.e., which is on) when the gate to source bias is zero.

A field effect transistor (FET) can be formed so that current is conducted in a lateral direction between a drain and source separated at the device surface. Examples of a lateral GaN FET include a high electron mobility transistor (HEMT) which avails high conductivity due to a two-dimensional electron gas (2DEG) formed between a GaN layer and an aluminum gallium nitride (AlGaN) layer.

Alternatively, an FET can also be formed so that current is conducted in a vertical direction between a drain at the device bottom and a source at the device surface. Examples of vertical GaN FETs include current aperture vertical electron transistors (CAVETs), trench metal-oxide field effect transistors (MOSFETs), and fin field effect transistors (FinFETs).

### SUMMARY OF THE DISCLOSURE

State-of-the-art GaN HEMTs achieve high breakdown voltages (e.g., one-thousand volts) with low specific on resistance defined by the product of resistance with device area (e.g., milli-ohm centimeters squared). However, a disadvantage of the GaN HEMT is the phenomenon of "current collapse" which gives rise to an undesirable dynamic increase in on-resistance. Moreover, for applications requiring higher breakdown voltages (e.g., two thousand volts), a vertical GaN FET becomes an attractive alternative to the lateral GaN HEMT; as a vertical GaN transistor may offer lower specific on-resistance, higher breakdown voltage, and better device reliability.

As mentioned above, there has been development of vertical GaN power FETs including CAVETs, trench MOSFETs, and FinFETs. Unfortunately, CAVETs, trench MOSFETs, and FinFETs involve complicated processing steps. For instance, CAVETs and trench MOSFETs necessitate the formation of p-type GaN layers which may be difficult to reliably process. Moreover, although FinFETs may be fabricated without p-type GaN, the resulting narrow fin, typically between zero point one eight microns (0.18um) and zero point four microns (0.4um), may be difficult to reliably produce and require costly fabrication techniques (e.g., electron beam lithography).

Accordingly, there is a need to develop a vertical GaN transistor suitable as a power FET without the limitations of the current state-of-the-art CAVETs, trench MOSFETs, and FinFETs.

This disclosure introduces a new vertical GaN transistor (i.e., a vertical GaN FET), unlike the CAVET, trench MOSFET, and FinFET. According to the teachings herein, a vertical GaN FET includes cylindrical trench gates arranged in a hexagonal array to form vertical FET channels. At the surface of the vertical GaN FET is a source layer formed in a GaN epitaxial layer and over a GaN substrate. A channel may be formed between the cylindrical gates in the form of a "GaN pillar"; and FET characteristics, including threshold voltage, may be determined, at least in part by a trench nearest neighbor distance. Accordingly, the trench nearest neighbor distance may be selected so that the vertical GaN FET operates as either an enhancement mode or a depletion mode transistor.

### BRIEF DESCRIPTION OF THE DRAWINGS

Non-limiting and non-exhaustive embodiments of vertical gallium nitride transistors are described with reference to the following figures, wherein like reference numerals refer to like parts throughout the various views unless otherwise specified.
**FIG. 1A** illustrates a cross-sectional perspective view of a vertical GaN transistor according to an embodiment.
**FIG. 1B** illustrates a two-dimensional (2D) top view of the vertical GaN transistor of FIG. 1A.
**FIG. 1C** illustrates another two-dimensional (2D) top view of the vertical GaN transistor of FIG. 1A.
**FIG. 2** illustrates a three-dimensional (3D) side perspective view of a vertical GaN transistor.
**FIG. 3A** illustrates a two dimensional (2D) cross sectional view of the portion of the vertical GaN transistor depicted in FIG. 2.
**FIG. 3B** illustrates a plot of doping concentration according to the embodiment of FIG. 3A.
**FIG. 4** illustrates another three-dimensional (3D) side perspective view of a vertical GaN transistor.
**FIG. 5A** illustrates a two dimensional (2D) cross sectional view of a vertical GaN transistor.
**FIG. 5B** illustrates another two dimensional (2D) cross sectional view of a vertical GaN transistor.
**FIG. 6** illustrates transfer curves of simulated drain current.
**FIG. 7A** illustrates a cut plane corresponding with a first transfer curve of FIG. 6.
**FIG. 7B** illustrates a cut plane corresponding with a second transfer curve of FIG. 6.
**FIG. 7C** illustrates a cut plane corresponding with a third transfer curve of FIG. 6.
**FIG. 7D** illustrates a cut plane corresponding with a fourth transfer curve of FIG. 6.
**FIG. 7E** illustrates a cut plane corresponding with a fifth transfer curve of FIG. 6.
**FIG. 8** illustrates another three-dimensional (3D) side perspective view of a vertical GaN transistor.
**FIG. 9** illustrates a plot of electric field according to the embodiment of FIG. 8.
**FIG. 10** illustrates a transfer curve of simulated drain current.
**FIG. 11** illustrates a cut plane corresponding with the transfer curve of FIG. 10.
**FIG. 12A** illustrates a two dimensional (2D) cross sectional view according to the embodiment of FIG. 10.
**FIG. 12B** illustrates transfer curves of electron density according to the embodiment of FIG. 10.
**FIG. 13A** illustrates a cut plane of a vertical GaN transistor.
**FIG. 13B** illustrates transfer curves according to the embodiment of FIG. 13A.
**FIG. 13C** illustrates additional transfer curves according to the embodiment of FIG. 13A.
**FIG. 14** illustrates a cross-sectional perspective view of a vertical GaN transistor according to another embodiment.
**FIG. 15A** illustrates a two dimensional (2D) cross sectional view of the vertical GaN transistor of FIG. 14.
**FIG. 15B** illustrates a magnified view corresponding with FIG. 15A.
**FIG. 15C** illustrates a plot of electron density corresponding with the cross section of FIG. 15A.
**FIG. 16** illustrates a transfer curve according to the embodiment of FIG. 14
**FIG. 17** illustrates transfer curves of electron density according to the embodiment of FIG. 16.
**FIG. 18A** illustrates another two dimensional (2D) cross sectional view of the vertical GaN transistor of FIG. 14.
**FIG. 18B** illustrates a plot of electric field according to the embodiment of FIG. 18A.

Corresponding reference characters indicate corresponding components throughout the several views of the drawings. Skilled artisans will appreciate that elements in the figures are illustrated for simplicity and clarity and have not necessarily been drawn to scale. For example, the dimensions of some of the elements and layers in the figures may be exaggerated relative to other elements to help improve understanding various embodiments of the teachings herein. Also, common but well-understood elements, layers, and/or process steps that are useful or necessary in a commercially feasible embodiment are often not depicted to facilitate a less obstructed view of these various embodiments of vertical gallium nitride transistors.

### DETAILED DESCRIPTION

In the following description, numerous specific details are set forth to provide a thorough understanding of vertical gallium nitride transistors. It will be apparent, however, to one having ordinary skill in the art that the specific detail need not be employed to practice the teachings herein. In other instances, well-known materials or methods have not been described in detail to avoid obscuring the present disclosure.

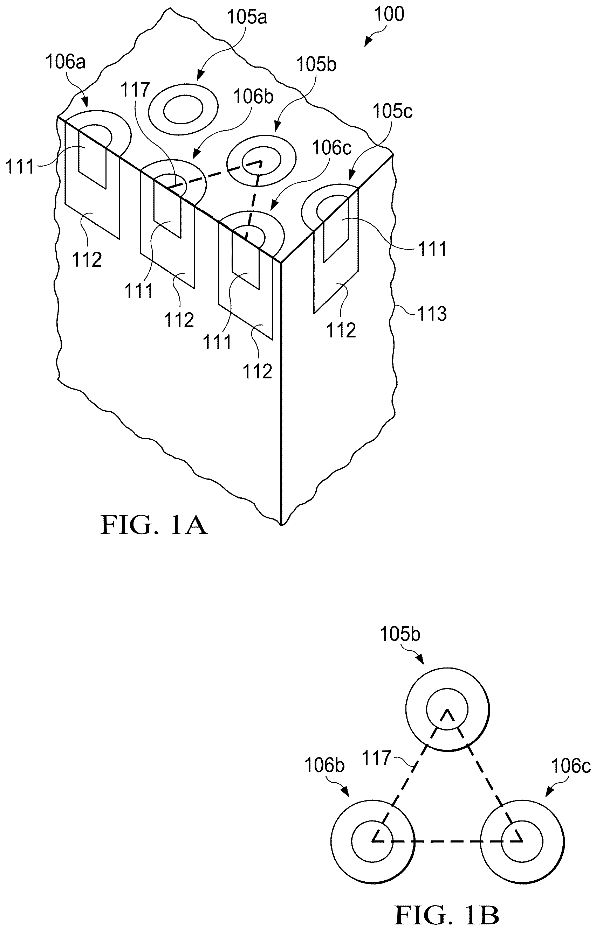

**FIG. 1A** illustrates a cross-sectional perspective view of a vertical GaN transistor 100 according to an embodiment. The vertical GaN transistor 100 includes cylindrical trench gates 105a-c and cylindrical trench gates 106a-c formed at the surface. Cylindrical trench gates 105a-c, 106a-c may be lined with a gate dielectric 112 (e.g., oxide) and filled with a gate electrode 111 (e.g., polysilicon and/or metal).

According to the teachings herein, the cylindrical trench gates 105a-c, 106a-c may be patterned (i.e., arranged) in a hexagonal array as viewed from above the surface. According to solid state physics, a two-dimensional hexagonal array may also be characterized by a triangular unit cell; consequently, cylindrical trench gates 105b, 106b, 106c form a triangular unit cell 117.

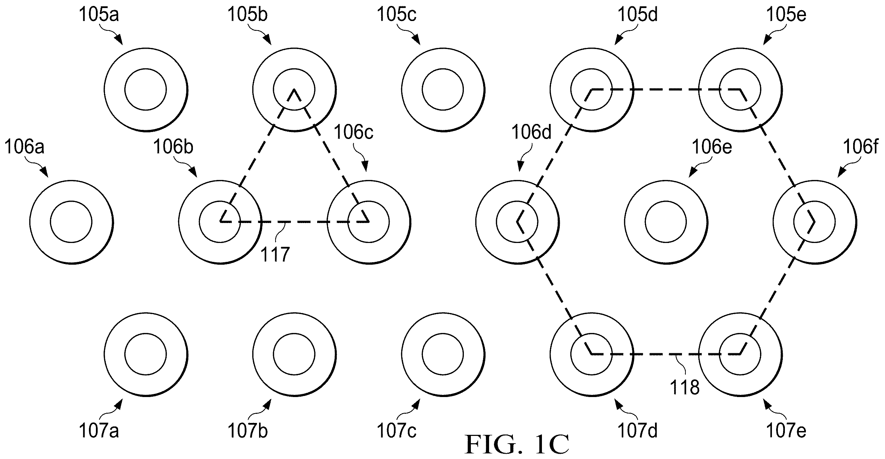

**FIG. 1B** illustrates a two-dimensional (2D) top view of the vertical GaN transistor 100 of FIG. 1A. The 2D top view shows the placement of cylindrical trench gates 105b, 106b, 106c. Based on their proximity, cylindrical trench gates 105b, 106b, 106c may be referred to as "nearest neighbors." As discussed above with regards to FIG. 1A, cylindrical trench gates 105b, 106b, 106c form a triangular unit cell 117 and may also be characterized as part of a hexagonal array as displayed in FIG. 1C.

**FIG. 1C** also illustrates a two-dimensional (2D) top view of the vertical GaN transistor 100 of FIG. 1A. The 2D top view of FIG. 1C shows the placement of cylindrical trench gates 105a-e, 106a-f, 107a-e; and as discussed above with regards to FIG. 1A-B, cylindrical trench gates 105b, 106b, 106c form a triangular unit cell 117. Also, according to the teachings herein, due to their proximity cylindrical trench gates 105b, 106b, 106c of triangular unit cell 117 may also be referred to as "nearest neighbors".

Alternatively, and additionally, cylindrical trench gates 105d-e, 106d-f, 107d-e also form a hexagonal unit cell 118 with cylindrical trench gate 106e located at its center. Therefore, based on their proximity, cylindrical trench gates 105d-e, 106d, 106f, 107d-e may be nearest neighbors to cylindrical trench gate 106e.

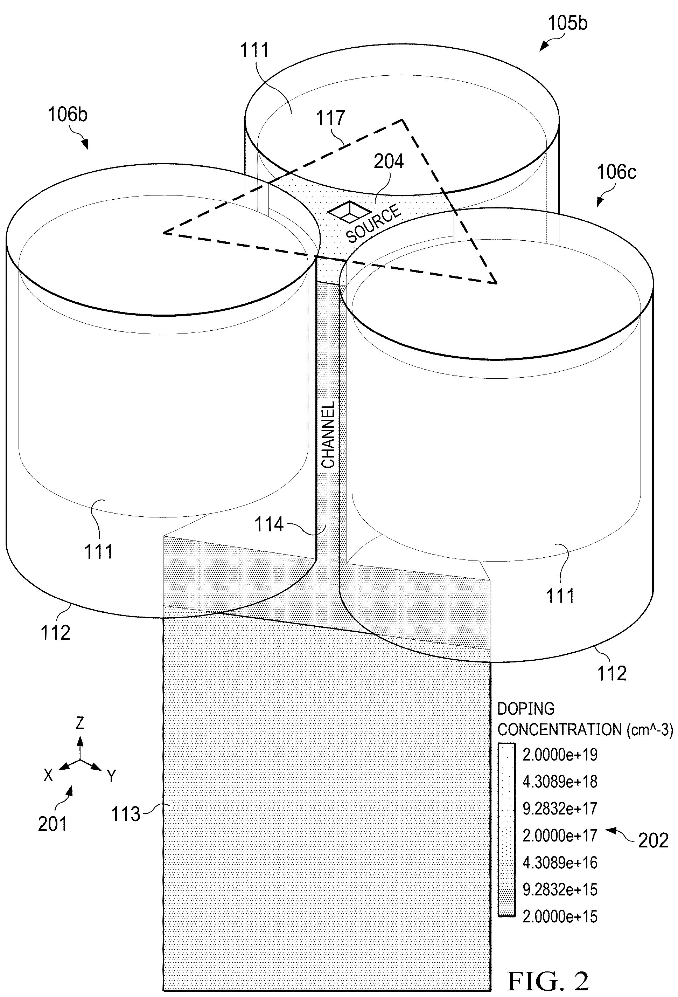

**FIG. 2** illustrates a three-dimensional (3D) side perspective view of the vertical GaN transistor 100. The 3D side perspective view illustrates a portion of the vertical GaN transistor 100 including cylindrical trench gates 105b, 106b, 106c. As discussed above cylindrical trench gates 105b, 106b, 106c may be nearest neighbors forming a triangular unit cell 117. Doping concentration may be depicted according to a doping concentration key 202; and coordinates are defined relative to cartesian axes 201.

According to the teachings herein, the cylindrical trench gates 105b, 106b, 106c may be formed to extend from the surface into channel epitaxy layer 114 and above a drift epitaxy layer 113. For instance, the cylindrical trench gates 105b, 106b, 106c may extend two microns (2um) into the channel epitaxial layer 114. Channel epitaxy (epi) layer 114 and drift epi layer 113 may be GaN epitaxial layers having different n-type doping concentrations. A source layer 204 may be a heavily doped n-type layer formed at the surface. Additionally, channel epi layer 114 including the source layer 204 may form a "GaN pillar" between the cylindrical trench gates 105b, 106b, 106c.

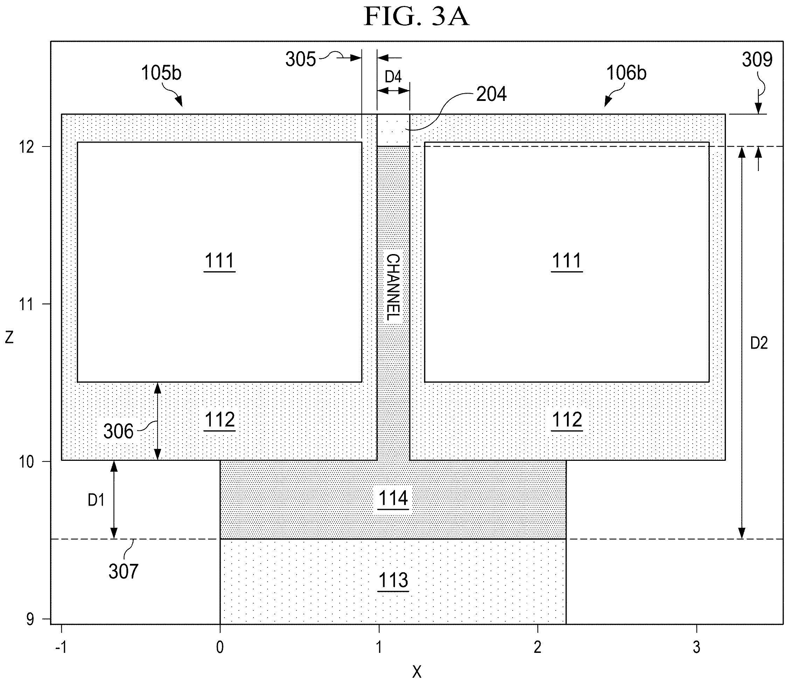

**FIG. 3A** illustrates a two dimensional (2D) cross sectional view of the portion of the vertical GaN transistor 100 depicted in FIG. 2. The 2D cross sectional view displays a cross section of vertical GaN transistor 100 in the XZ plane as defined by cartesian axes 201. Coordinate values in microns are indicated on both the X-axis and Z-axis. The source layer depth 309 may be the depth the source layer 204 extends into the channel epi layer 114 from the surface of the vertical GaN transistor 100. As illustrated the source layer depth 309 may be delineated from the surface of the vertical GaN transistor 100 to twelve microns (12um).

Distance D1 may be the distance the channel epi layer 114 extends past the bottom of the cylindrical trench gates 105b, 106b to junction 307 (i.e., a drift-to-trench-bottom distance). Distance D1 may be zero point five microns (0.5um); and junction 307 may be where epitaxial doping transitions. For instance, junction 307 may locate an abrupt junction where the doping concentration transitions from a lower concentration in the channel epi layer 114 to a higher concentration in the drift epi layer 113.

Trench nearest neighbor distance D4 is a GaN mesa width (a shortest distance) between neighboring cylindrical trench gates (e.g., between cylindrical trench gate 105b and cylindrical trench gate 106b). Trench nearest neighbor distance D4 may be zero point two microns (0.2um).

Sidewall thickness 305 may be the sidewall distance the gate dielectric 112 extends beyond the gate electrode 111. Sidewall thickness 305 may be between zero point zero two microns (0.02um) and zero point one microns (0.1um).

Dielectric thickness 306 may be a bottom oxide thickness.

According to the physics of semiconductor devices, a threshold voltage of vertical GaN transistor 100 may depend, at least in part, upon sidewall thickness 305, the doping concentration of the channel epi layer 114 and/or a work function of gate electrode 111. For a vertical GaN transistor 100 rated for one-thousand two-hundred volts, the channel epi layer 114 may have a doping concentration of two times ten to the power of fifteen inverse centimeters cubed (2e15cm-3). The gate electrode 111 may be heavily doped p-type polysilicon (P+poly) with a work function of five-point one electron volts (5.1eV). Additionally, dielectric thickness 306 may be zero point five microns (0.5um).

According to the teachings herein, using a triangular unit cell 117 layout of cylindrical trench gates 105b, 106b, 106c, may advantageously accomplish the realization of a superior, less complicated vertical GaN transistor 100. For instance, the cylindrical trench gates may be processed without the need for electron beam lithography.

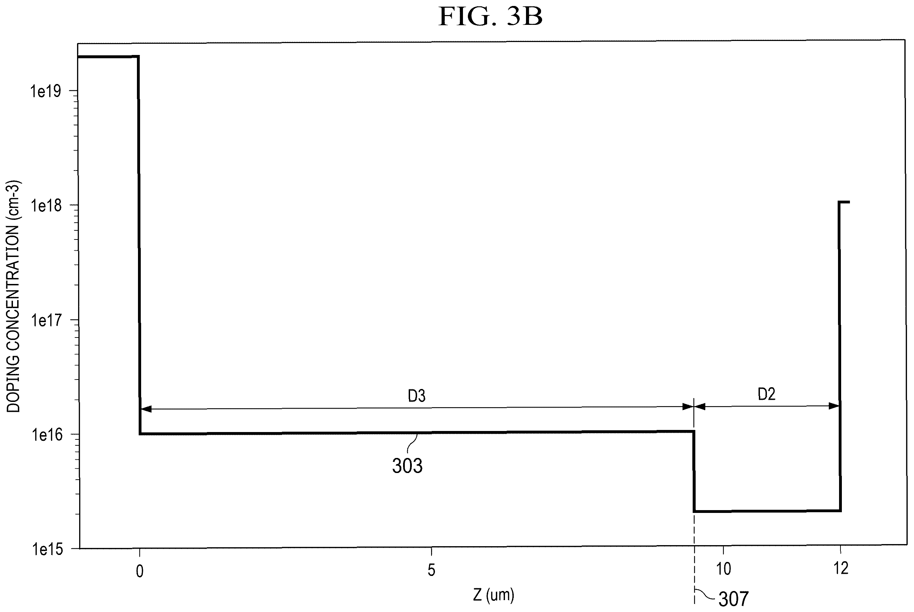

**FIG. 3B** illustrates a plot 303 of doping concentration according to the embodiment of FIG. 3A. With reference to FIG. 3A, plot 303 may be at (correspond with) an X-axis coordinate value of one micron (1um). The Z-axis values may extend between negative coordinate values and positive coordinate values and pass through the source layer 204. Doping concentration may be n-type and, under equilibrium conditions, may also correspond with equilibrium carrier concentration.

As illustrated, Z-axis coordinate zero (0) may define a location of a GaN substrate surface. As one of skill in the art may appreciate, epitaxy and epi layers (e.g., drift epi layer 113) may be grown on GaN substrates having a greater doping concentration than that of the drift epi layer 113. Channel length D2 may be the thickness of the channel epi layer 114 between the source layer (at z=12um) and junction 307. Channel length D2 may be two point five microns (2.5um). Z-axis coordinates less than zero may correspond to and be located within the GaN substrate.

The GaN substrate may function as a drain of the vertical GaN transistor 100. The doping concentration of the GaN substrate may be greater than one times ten to the nineteenth inverse centimeters cubed (1e19cm-3). For instance, the GaN substrate may have a doping concentration of three times ten to the nineteenth inverse centimeters cubed (3e19cm-3). The doping concentration (carrier concentration) of the channel epi layer 114 may be between ten to the fifteenth inverse centimeters cubed (1e15cm-3) and five times ten to the fifteenth inverse centimeters cubed (5e15cm-3). The doping concentration (carrier concentration) of the source layer 204 may be on the order of ten to the eighteenth inverse centimeters cubed (1e18cm-3) between nine times ten to the seventeenth inverse centimeters cubed (9e17cm-3) and two times ten to the eighteenth inverse centimeters cubed (2e18cm-3).

Drift epi layer thickness D3 may be the thickness of the drift epi layer 113 extending between junction 307 and Z-axis coordinate zero (z=0). Drift epi layer thickness D3 may be nine point five microns (9.5um). The doping concentration (carrier concentration) of the drift epi layer 113 may be on the order of ten to the sixteenth inverse centimeters cubed (1e16cm-3) between nine times ten to the fifteenth inverse centimeters cubed (9e15cm-3) and two times ten to the sixteenth inverse centimeters cubed (2e16cm-3). Although plot 303 of the carrier concentration (doping concentration) shows abrupt profile transitions at coordinates z=0, 12 and at junction 307, other profiles are possible. For instance, instead of abrupt transitions, the doping concentration (carrier concentration) may be graded and have a more gradual, less abrupt, slope at coordinates z-0,12 and at junction 307.

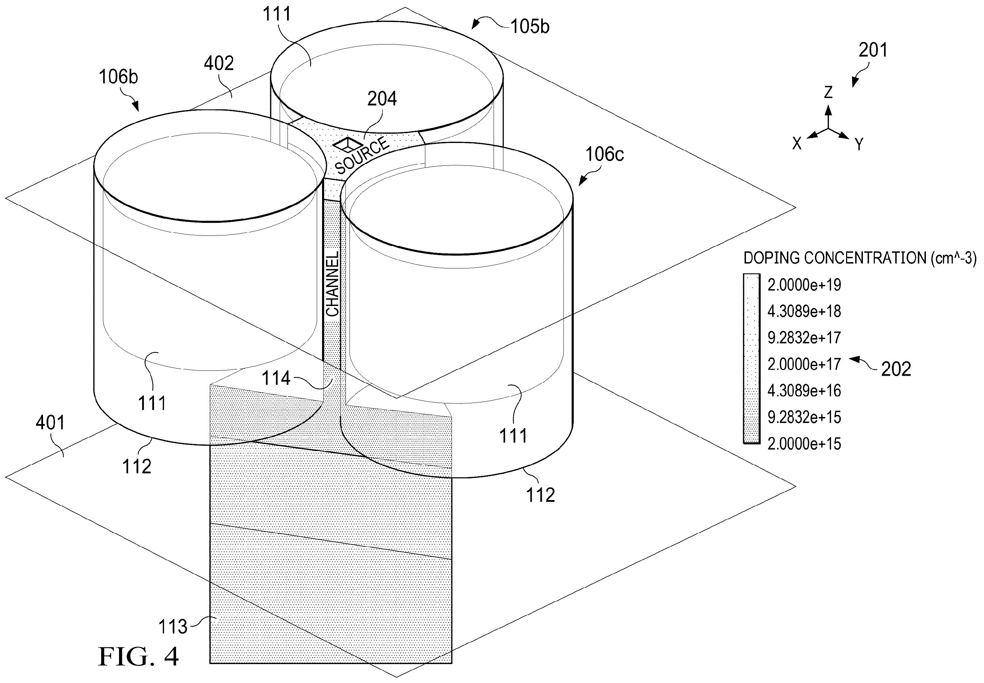

**FIG. 4** illustrates another three-dimensional (3D) side perspective view of vertical GaN transistor 100. Unlike that of FIG. 2, the 3D side perspective view also includes a cut plane 401 and cut plane 402. Cut plane 401 includes (passes through) the drift epi layer 113. Cut plane 402 may be parallel to cut plane 401 and includes (passes through) the cylindrical trench gates 105b, 106b, 106c.

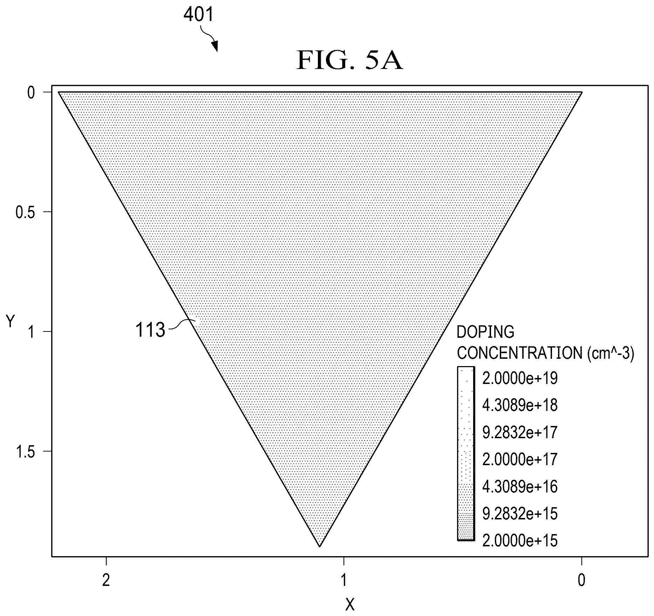

**FIG. 5A** illustrates a two dimensional (2D) cross sectional view of vertical GaN transistor 100 along cut plane 401. Cut plane 401 may include the XY-plane (i.e., X-axis and Y-axis coordinates) at a fixed Z-axis coordinate and show doping concentration corresponding with the fixed Z-axis coordinate of the drift epi layer 113. For instance, the doping concentration may be a uniform value of one times ten to the sixteenth inverse centimeters cubed (1e16cm-3).

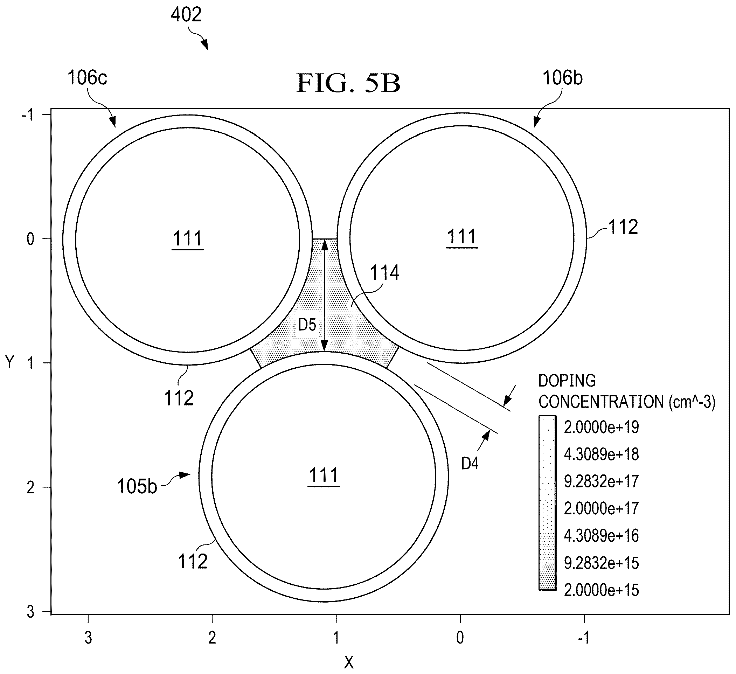

**FIG. 5B** illustrates another two dimensional (2D) cross sectional view of vertical GaN transistor 100 along cut plane 402. Cut plane 402 may correspond with a Z-axis coordinate of the channel epi layer 114 that also includes the cylindrical trench gates 105b, 106b, 106c. Along cut plane 402, doping within the cylindrical trench gates 105b, 106b, 106c may differ from that within channel epi layer 114.

As discussed above, trench nearest neighbor distance D4 may be the (shortest) distance between neighboring cylindrical trench gates (e.g., between neighboring cylindrical trench gates 105b, 106b) and may be zero point two microns (0.2um). Also, as illustrated distance D5 may be a widest distance of the channel epi layer 114 confined between the cylindrical trench gates 105b, 106b, 106c and on cut plane 402. For instance, distance D5 may be zero point nine microns (0.9um) while nearest neighbor distance D4 is zero point two microns (0.2um).

Accordingly, as seen from the 2D cross sectional view on cut plane 402, the channel epi layer 114 forms a "wedge" varying in width between 0.2um (the nearest neighbor distance D4) and 0.9um (distance D5). According to the teachings herein, the formation of a "wedge" between cylindrical trench gates 105b, 106b, 106c may avail the realization of a superior, less complicated vertical GaN transistor 100.

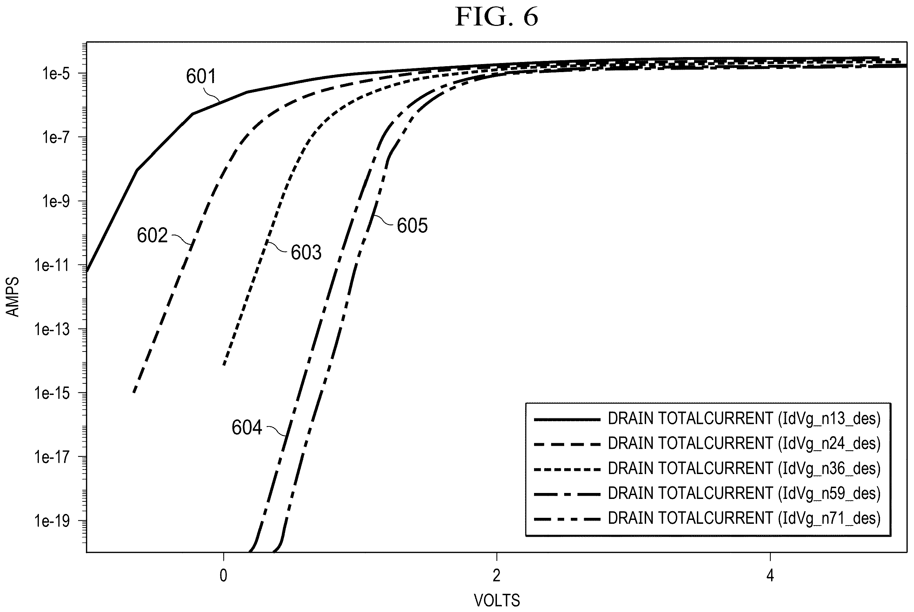

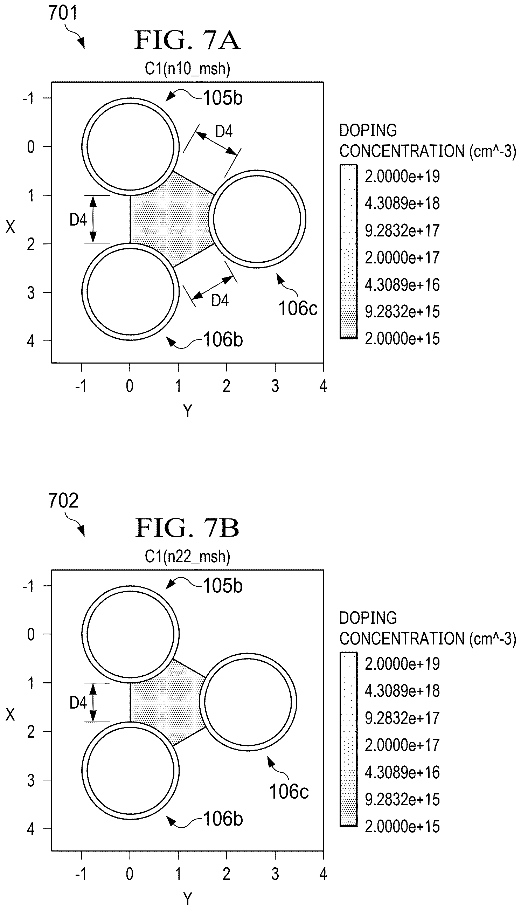

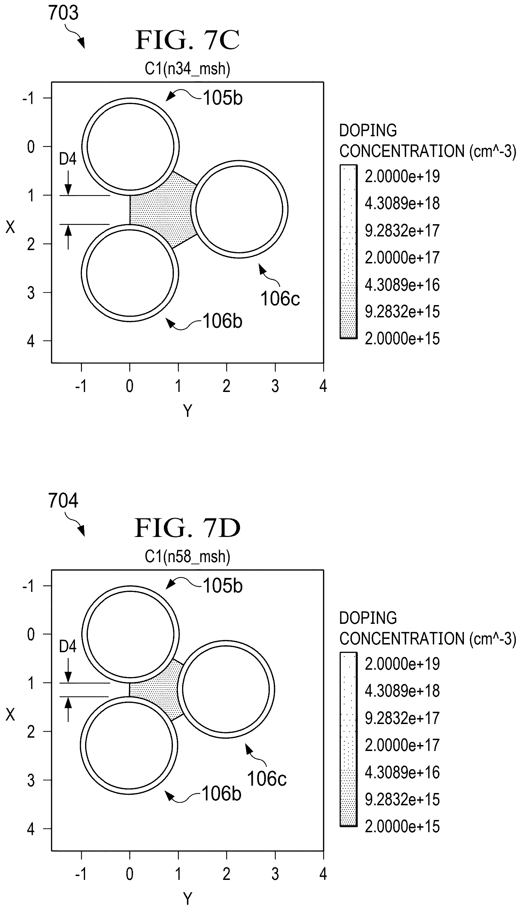

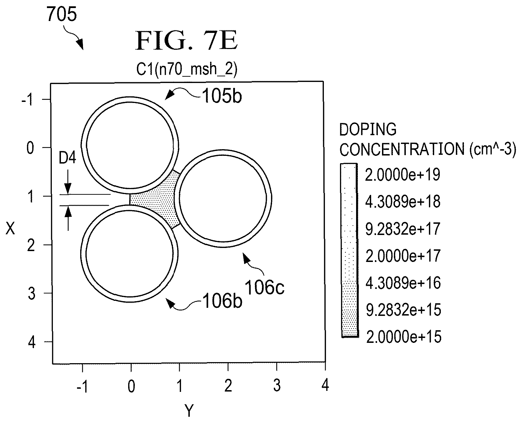

**FIG. 6** illustrates transfer curves 601-605 of simulated drain current in amperes (amps); and **FIGs. 7A-7E** illustrate cut planes 701-705 respectively corresponding with transfer curves 601-605. Drain current is plotted as a function of gate-to-source voltage VGS in volts for monotonically decreasing values of nearest neighbor distance D4 as respectively conveyed by cut planes 701-705. For instance, cut plane 701 may correspond with a nearest neighbor distance D4 equal to one micron (1um). Cut plane 702 may correspond with a nearest neighbor distance D4 equal to zero point eight microns (0.8um). Cut plane 703 may correspond with a nearest neighbor distance D4 equal to zero point six microns (0.6um). Cut plane 704 may correspond with a nearest neighbor distance D4 equal to zero point six microns (0.4um); and cut plane 705 may correspond with a nearest neighbor distance D4 equal to zero point two microns (0.2um). The drain-to-source voltage VDS may be one volt (1V). The specific on resistance Rsp may be approximately one milli-ohm centimeter squared (mohm-cm^2). For instance, the specific on resistance Rsp may be one-point zero six milli-ohm centimeters squared (1.06 mohm-cm^2).

According to the practice of semiconductor devices, a field effect transistor threshold voltage may be quantified by measuring gate-to-source voltage VGS at a specified fixed drain current. For instance, a threshold voltage Vth may be defined based on a current of ten to the minus eleventh (1e-11) amperes. Accordingly, as nearest neighbor distance D4 decreases, threshold voltage Vth may increase. Therefore, as illustrated by transfer curves 601-605, the threshold voltage Vth, as defined above, increases from negative values to positive values ranging from minus one volt (-1V) to positive one volt (1V).

Also, according to the practice of semiconductor devices, negative values of threshold voltage Vth may correspond with depletion mode operation; and positive values of threshold voltage Vth may correspond with enhancement mode operation. Thus, as the spacing between the cylindrical trench gates 105b, 106b, 106c decreases (i.e., as the nearest neighbor distance D4 decreases), the threshold voltage increases from negative values to positive values.

Accordingly, the threshold voltage and mode of operation (depletion mode, enhancement mode) may be determined, at least in part, by the nearest neighbor distance D4. According to the teachings herein, the vertical GaN transistor 100 may be enhancement mode (i.e., have a threshold voltage greater than zero) or depletion mode (i.e., have a threshold voltage less than zero) based, at least in part, on the nearest neighbor distance D4. Additionally, subthreshold slope, a quantity relating to the slope of transfer curves 601-605, may be determined, at least in part, by sidewall thickness 305.

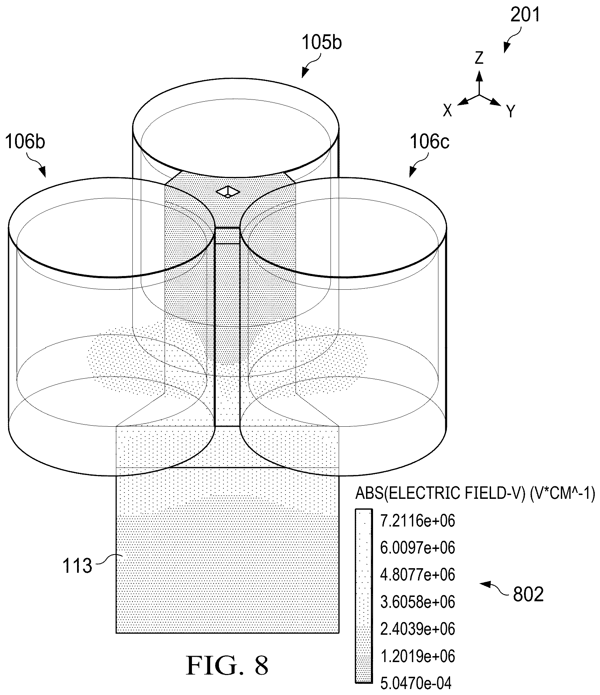

**FIG. 8** illustrates another three-dimensional (3D) side perspective view of vertical GaN transistor 100. The 3D side perspective view is like that of FIG. 2 except it illustrates electric field profile instead of doping concentration. The electric field may be due to an applied drain-to-source voltage VDS. For instance, the applied drain-to-source voltage VDS may be one thousand five hundred volts (1500V). Electric field may be defined with respect to electric field key 802 and have units of volts per centimeter (V/cm).

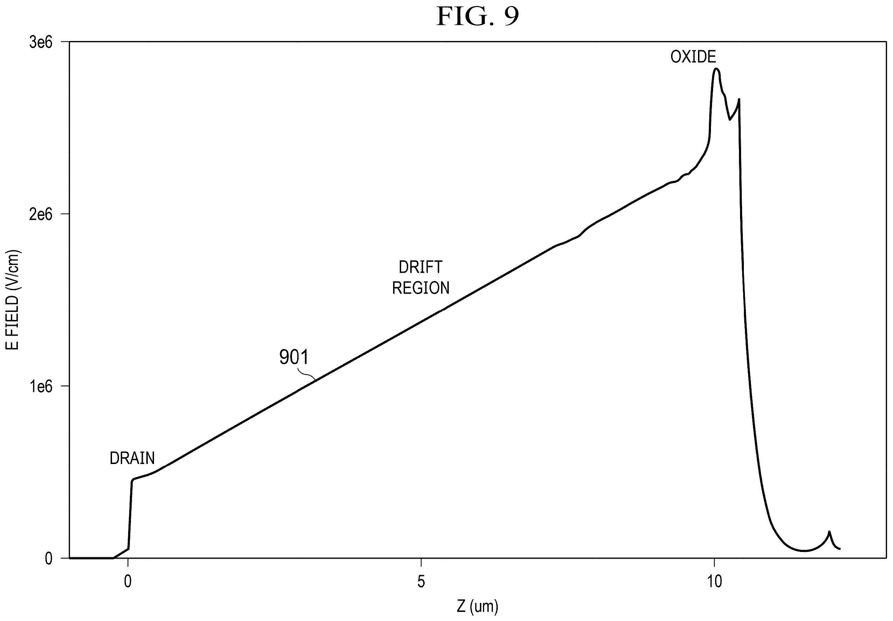

**FIG. 9** illustrates a plot 901 of electric field according to the embodiment of FIG. 8. The applied drain-to-source voltage VDS may be 1500V. The electric field increases monotonically from the substrate surface at Z-axis coordinate equal to zero (z=0) and is greatest within the gate dielectric 112 (near z=10um).

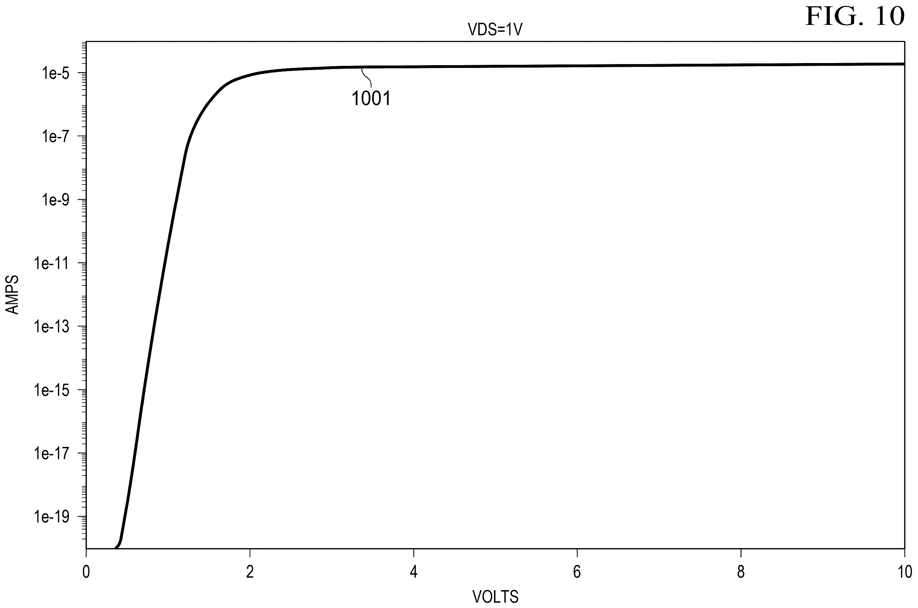

**FIG. 10** illustrates a transfer curve 1001 of simulated drain current in amperes as a function of gate-to-source voltage VGS in volts. The applied drain-to-source voltage VDS may be one volt (1V). The dielectric 112 may be oxide. The sidewall thickness 305 may be zero point one microns (0.1um). The doping concentration in the channel epi layer 114 may be n-type of concentration two times ten to the fifteenth inverse centimeters cubed (2e15cm-3). A simulated threshold voltage Vth, based on subthreshold slope, may be greater than one volt. For instance, the simulated threshold voltage Vth, based on subthreshold slope, may equal one point three volts (1.3V). Additionally, the calculated specific on-resistance Rsp may be equal to one point zero six milli-ohm centimeters squared (1.06 mohm-cm^2).

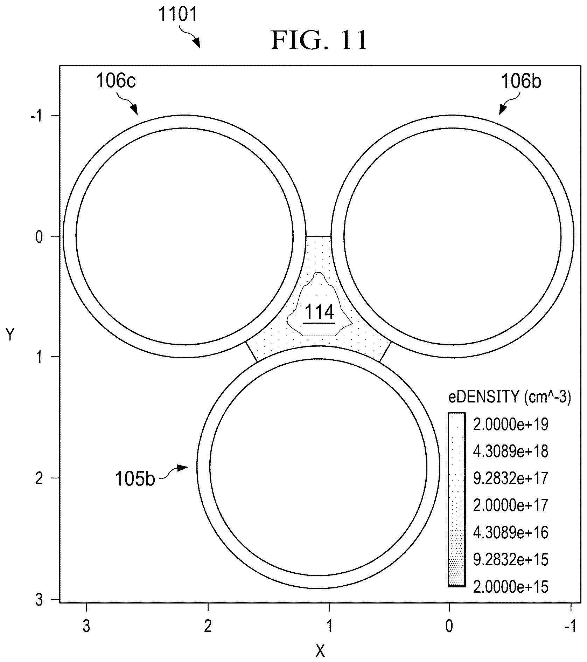

**FIG. 11** illustrates a cut plane 1101 corresponding with transfer curve 1001. Cut plane 1101 may be in the XY-plane of vertical GaN transistor 100. Like the cut planes 701-705, cut plane 1101 includes the cylindrical trench gates 105b, 106b, 106c and the channel epi layer 114. The drain-to-source voltage VDS may be one volt (1V). The gate-to-source voltage VGS may be equal to one point five volts (1.5V). The carrier concentration under these conditions (i.e., drain-to-source voltage VDS=1V, gate-to-source voltage VGS=1.5V), may be approximately ten to the twelfth inverse centimeters cubed (1e12cm-3).

As gate-to-source voltage VGS varies from zero volts (0V) to five volts (5V), the (electron) carrier concentration in the channel epi layer 114 may vary from approximately ten to the minus nineth inverse centimeters cubed (1e-9cm-3) to approximately ten to the nineteenth inverse centimeters cubed (1e19cm-3). When gate-to-source voltage VGS is zero volts, the carriers (i.e., electrons) are depleted and the simulated carrier concentration may be approximately ten to the minus ninth inverse centimeters cubed (1e-9cm-3). When the gate-to-source voltage VGS is zero point five volts (0.5V) the carrier concentration increases to approximately ten to the third inverse centimeters cubed (1e3cm-3). When the gate-to-source voltage VGS is five volts (5V), the carrier concentration increases to approximately ten to the nineteenth inverse centimeters cubed (1e19cm-3).

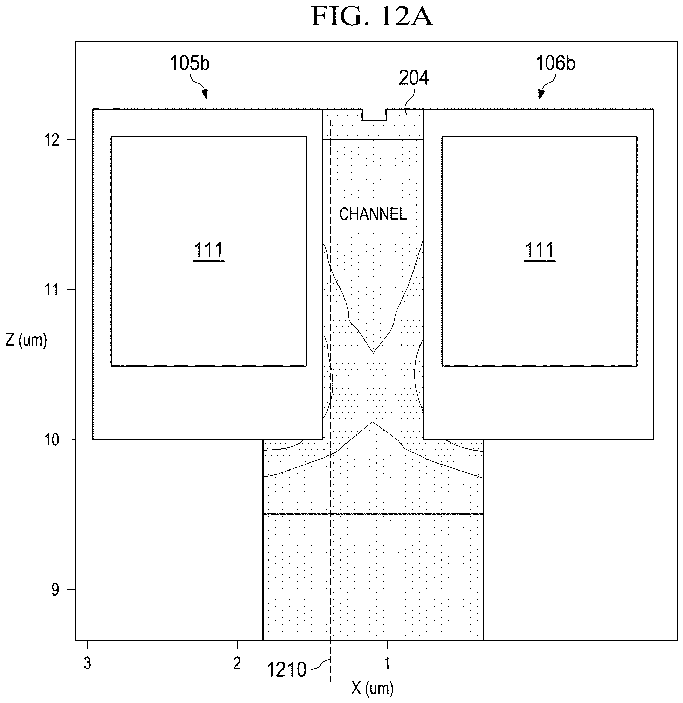

**FIG. 12A** illustrates a two dimensional (2D) cross sectional view according to the embodiment of FIG. 10. The 2D cross sectional view is like that of FIG. 3A except it illustrates electron density instead of doping concentration. The units may be electrons (carriers) per centimeters cubed (cm-3). Cut line 1210 may correspond with an X-axis coordinate value of approximately one point five microns such that that the cut line 1210 remains within the channel epi layer 114 near cylindrical trench gate 105b. The drain-to-source voltage VDS may be one volt (1V). The gate-to-source voltage VGS may be equal to one point five volts (1.5V).

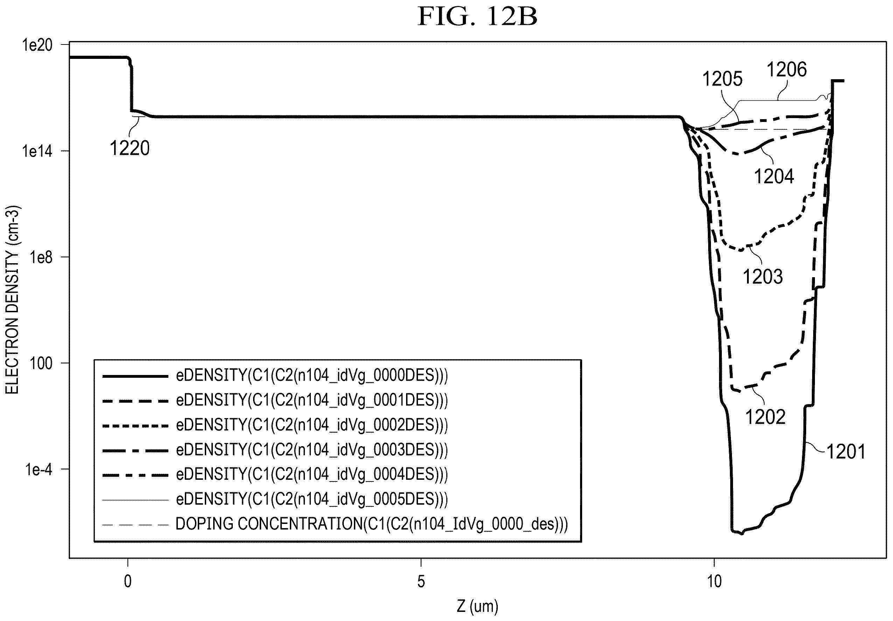

**FIG. 12B** illustrates transfer curves 1201-1206 of electron density along the Z-axis of cut line 1210 and according to the embodiment of FIG. 10. For reference, FIG. 12B also illustrates a 1D plot 1220 of doping concentration along cut line 1210. The drain-to-source voltage VDS may be one volt (1V). Transfer curve 1201 corresponds with a gate-to-source voltage VGS of zero volts (0V). Transfer curve 1202 corresponds with a gate-to-source voltage VGS of zero point five volts (0.5V). Transfer curve 1203 corresponds with a gate-to-source voltage VGS of one volt (1.0V). Transfer curve 1204 corresponds with a gate-to-source voltage VGS of one point five volts (1.5V). Transfer curve 1205 corresponds with a gate-to-source voltage VGS of two volts (2.0V); and transfer curve 1206 corresponds with a gate-to-source voltage VGS of five volts (5.0V).

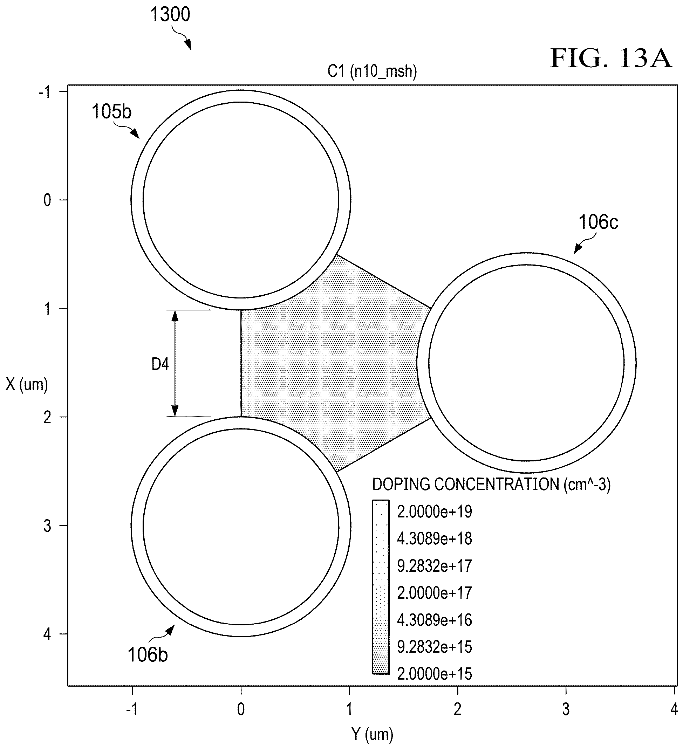

**FIG. 13A** illustrates a cut plane 1300 in the XY-plane for simulating transfer curves of vertical GaN transistor 100 with variable nearest neighbor distance D4.

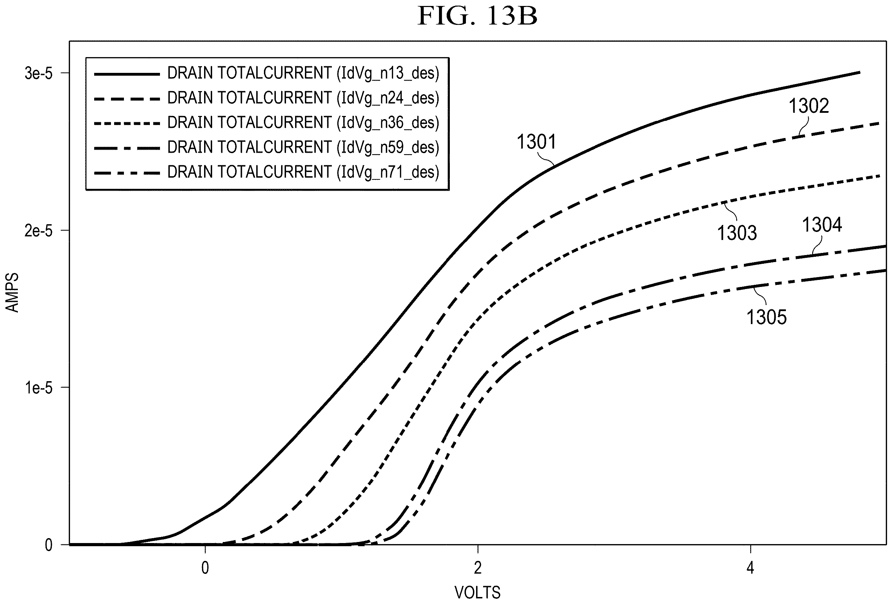

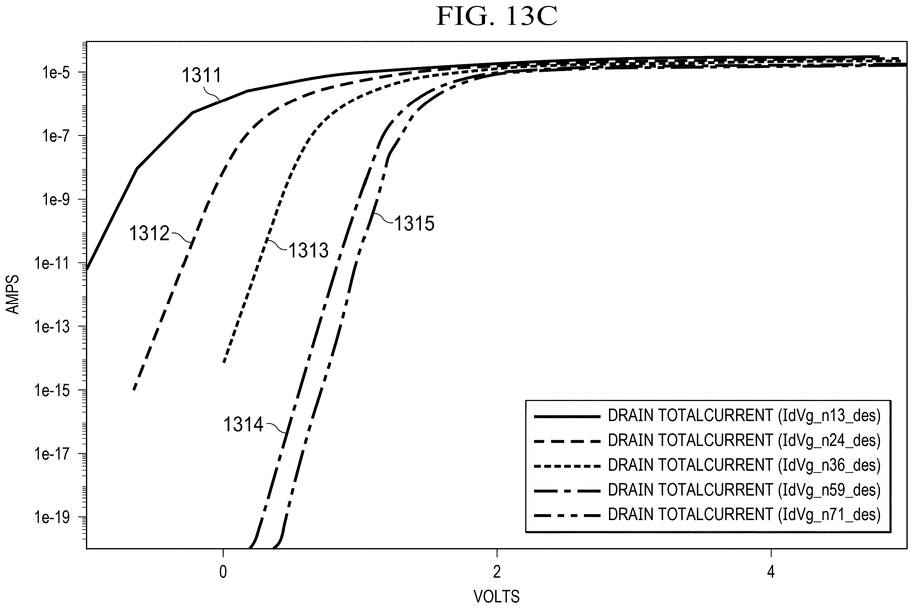

**FIG. 13B** illustrates transfer curves 1301-1305 of total drain current in amperes versus gate-to-source voltage VGS in volts; and **FIG. 13C** illustrates additional transfer curves 1311-1315 of total drain current versus gate-to-source voltage VGS. The transfer curves 1301-1305, 1311-1315 may be based on simulations using the cut plane 1300 of FIG. 13A. In FIG. 13B total drain current in amperes is plotted on a linear scale; and in FIG. 13C total drain current in amperes is plotted on a log scale. The drain-to-source voltage VDS may be one volt (1V).

Plotting amperes on a log scale may give graphical insight into the behavior of subthreshold slope. Subthreshold slope relates to the behavior of current (e.g., total drain current) as a function of gate-to-source voltage VGS; and during subthreshold operation (under subthreshold conditions) the drain current may be exponential, indicative of barrier dominated current flow.

Transfer curves 1301, 1311 may correspond with a nearest neighbor distance D4 of one micron (1um). Transfer curves 1302, 1312 may correspond with a nearest neighbor distance D4 of zero point eight microns (0.8um). Transfer curves 1303, 1313 may correspond with a nearest neighbor distance D4 of zero point six microns (0.6um). Transfer curves 1304, 1314 may correspond with a nearest neighbor distance D4 of zero point four microns (0.4um); and transfer curves 1305, 1315 may correspond with a nearest neighbor distance D4 of zero point two microns (0.2um).

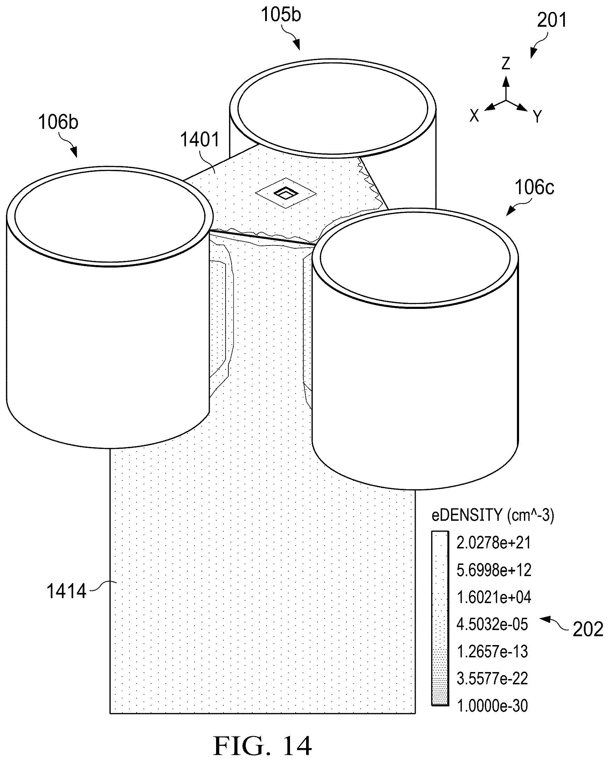

**FIG. 14** illustrates a cross-sectional perspective view of a vertical GaN transistor 100 according to another embodiment. Vertical GaN transistor 100 of FIG. 14 is like that of FIG. 1 except the source layer comprises a two-dimensional electron gas (2DEG). The surface of GaN transistor 100 of FIG. 14 may comprise an aluminum gallium nitride (AlGaN) layer 1401; and like that of a lateral GaN HEMT, the AlGaN layer 1401 may form an AlGaN to GaN interface which gives rise to a 2DEG. The 2DEG may advantageously provide a highly concentrated source of n-type carriers (i.e., electrons).

Additionally, instead of having a channel epi layer 114 and a drift epi layer 113, the vertical GaN transistor 1400 of FIG. 14 has an N-GaN epi layer 1414. The N-GaN epi layer 1414 may be n-type and doped uniformly; and although FIG. 14 illustrates the GaN transistor 100 as only having the N-GaN epi layer 1414 with uniform doping, other doping profiles may be possible. The N-GaN epi layer 1414 including the 2DEG and AlGaN may form a "GaN pillar" between the cylindrical trench gates 105b, 106b, 106c.

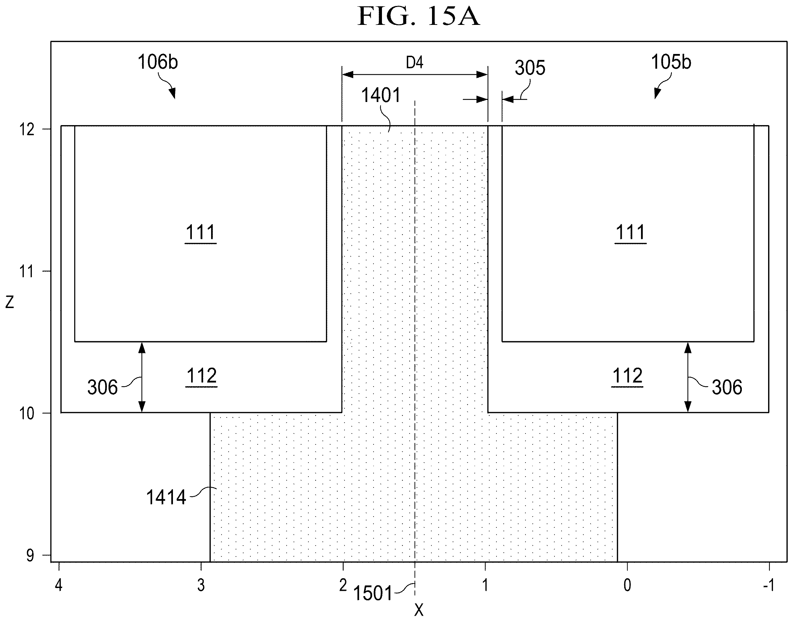

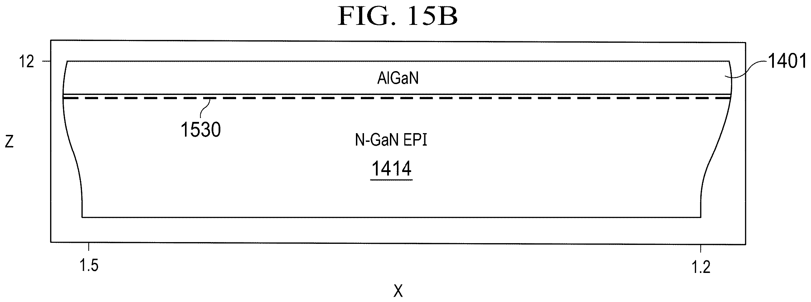

**FIG. 15A** illustrates a two dimensional (2D) cross sectional view corresponding with the embodiment of FIG. 14; and **FIG. 15B** illustrates a magnified view showing a 2DEG 1530 corresponding with FIG. 15A. The 2D cross sectional view displays a cross section of vertical GaN transistor 100 in the XZ plane as defined by cartesian axes 201. Coordinate values in microns are indicated on both the X-axis and Z-axis. As illustrated in FIG. 15B, the 2DEG 1530 may be formed between the AlGaN layer 1401 and N-GaN epi layer 1414.

Sidewall thickness 305 may be the sidewall distance the gate dielectric 112 extends beyond the gate electrode 111. The gate dielectric 112 may be oxide. Sidewall thickness 305 may be between zero point one (0.1um) and zero point five microns (0.5um). A device pinchoff characteristic may be determined, at least in part, by sidewall thickness 305 and a doping concentration of the N-GaN epi layer 1414. Nearest neighbor distance D4 may be between one micron (1um) and two microns (2um).

A breakdown voltage rating (e.g., maximum drain-to-source voltage rating) may depend, at least in part, upon the dielectric thickness 306. For instance, vertical GaN transistor 1400 with a dielectric thickness 306 of zero point five microns (0.5um) may have a breakdown voltage greater than one-thousand two-hundred volts (1200V).

The N-GaN epi layer 1414 may have a doping concentration of ten to the sixteenth inverse centimeters cubed (1e16cm-3). Cut line 1501 may correspond with an X-axis coordinate value of approximately one point five microns (1.5um).

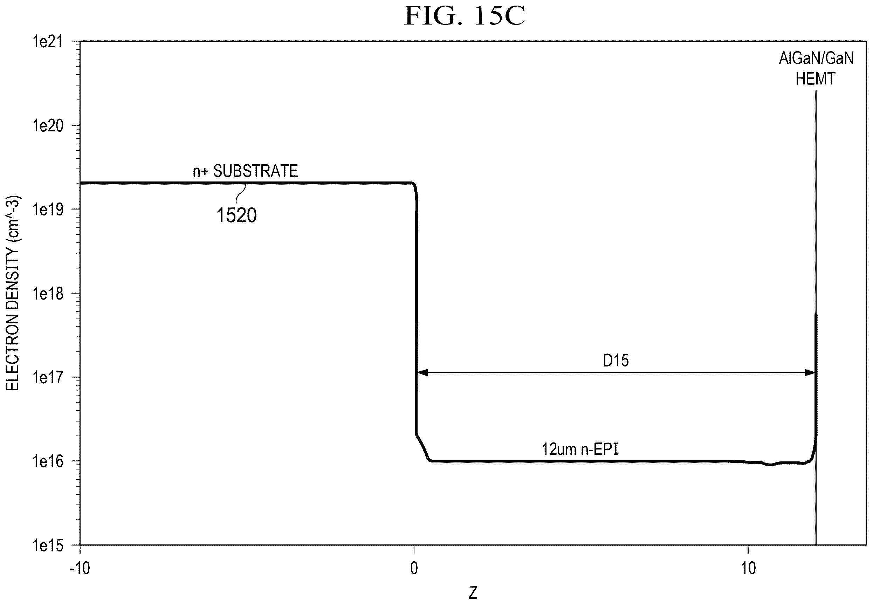

**FIG. 15C** illustrates a plot 1520 of electron density in inverse centimeters cubed (cm-3) along the Z-axis on cut line 1501. With reference to FIG. 15A, plot 1520 may be at (correspond with) an X-axis coordinate value of one point five microns (1.5um). The Z-axis coordinate values may extend between negative coordinate values and positive coordinate values and pass through the 2DEG 1530. Z-axis coordinate zero (0) may define a location of a GaN substrate surface. For Z-axis coordinate values less than zero (z<0), the electron density may be substantially equal to the n-type doping concentration of the GaN substrate. The doping concentration in the GaN substrate may be greater than one times ten to the nineteenth inverse centimeters cubed (1e19cm-3). Except for the 2DEG 1530 between the AlGaN layer 1401 and N-GaN epi layer 1414, the electron density may be substantially equal to the n-type doping concentration of the N-GaN epi layer 1414; and the n-type doping concentration of the N-GaN epi layer 1414 may be ten to the sixteenth inverse centimeters cubed (1e16cm-3). Distance D15, the N-GaN epi layer thickness, may be twelve microns (12um).

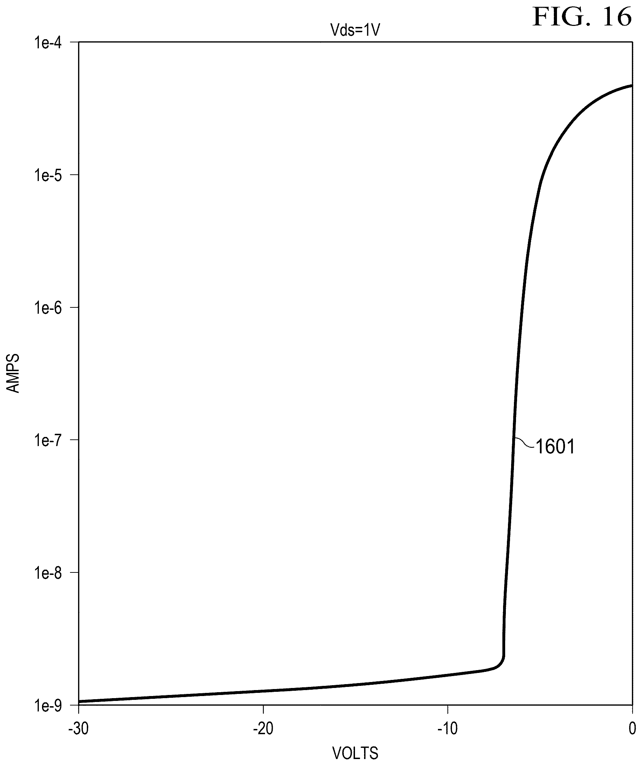

**FIG. 16** illustrates a transfer curve 1601 of simulated drain current in amperes (amps) as a function of gate-to-source voltage VGS in volts. The applied drain-to-source voltage VDS may be one volt (1V). The dielectric 112 may be oxide. The sidewall thickness 305 may be zero point one microns (0.1um). The doping concentration in the channel epi layer 1414 may be 1e16cm-3 and may be n-type. The calculated specific on-resistance Rsp may be equal to zero point seven two milliohm centimeters squared (0.72 mohm-cm^2); and the pinch-off voltage may be negative six volts (-6V). Accordingly, the vertical GaN transistor 1400 may be a depletion mode vertical GaN HEMT.

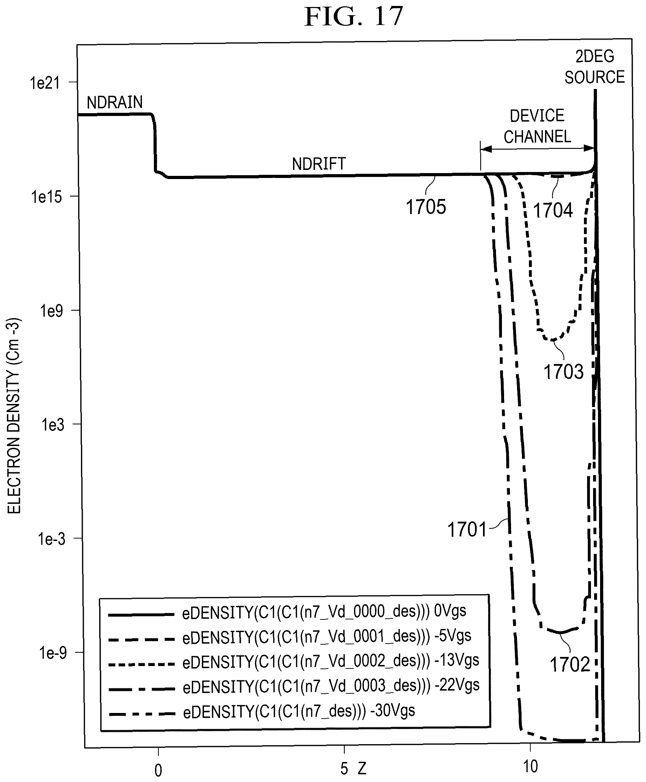

**FIG. 17** illustrates transfer curves 1701-1705 of electron density along the Z-axis of cut line 1501 according to the embodiment of FIG. 16. The drain-to-source voltage VDS may be one volt (1V). Transfer curve 1701 corresponds with a gate-to-source voltage VGS of minus thirty volts (-30V). Transfer curve 1702 corresponds with a gate-to-source voltage VGS of minus twenty-two volts (-22V). Transfer curve 1703 corresponds with a gate-to-source voltage VGS of minus thirteen volts (-13V). Transfer curve 1704 corresponds with a gate-to-source voltage VGS of minus five volts (-5V); and transfer curve 1705 corresponds with a gate-to-source voltage VGS of zero volts (0.0V).

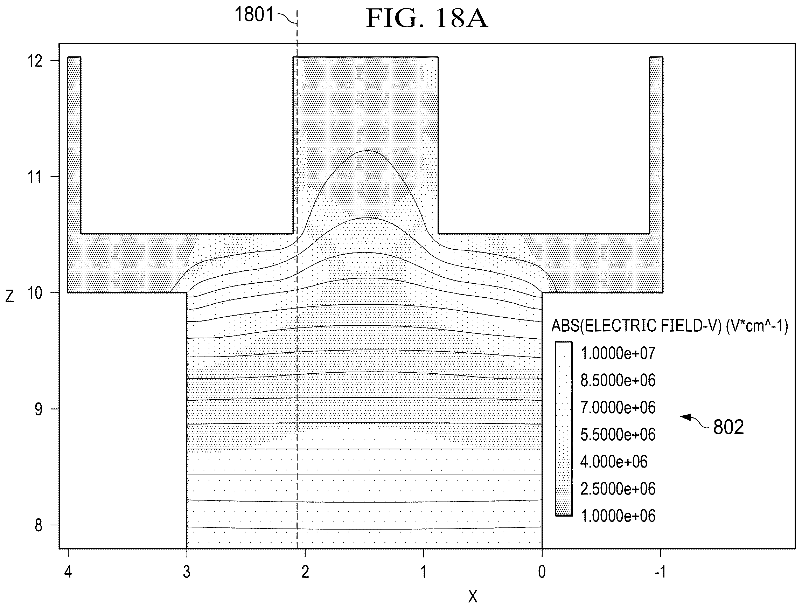

**FIG. 18A** illustrates another two dimensional (2D) cross sectional view according to the embodiment of FIG. 14. The 2D cross sectional view is like that of FIG. 15A except it illustrates electric field profile for an applied drain-to-source voltage of one thousand volts (1000V). The gate-to-source voltage VGS may be negative thirty volts (-30V). The units may be in volts per centimeter (V/cm) and according to the electric field key 802. Cut line 1801 may correspond with an X-axis coordinate value of approximately two microns such that that the cut line 1801 passes through the dielectric 112; and the dielectric 112 may be oxide.

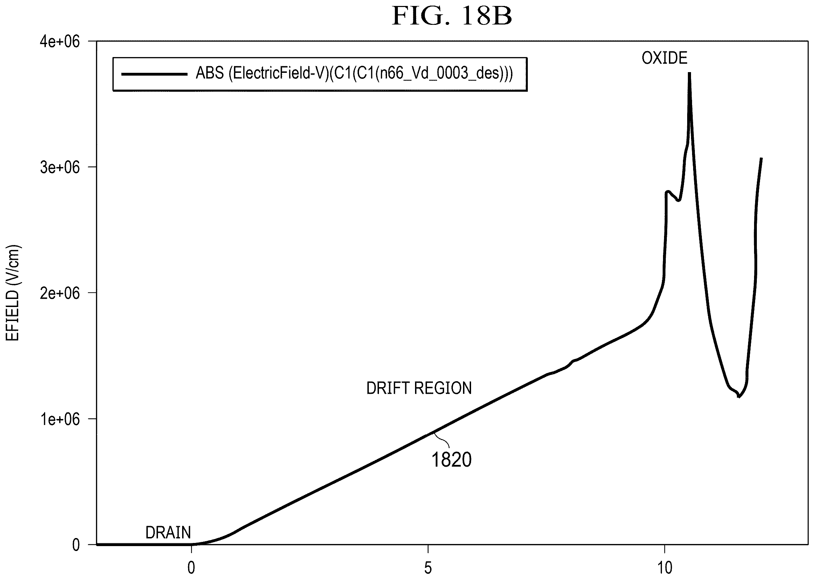

**FIG. 18B** illustrates a plot 1820 of electric field in volts per centimeter (V/cm) along the Z-axis according to the cut line 1801. The applied drain-to-source voltage VDS may be one thousand volts (1000V). The electric field increases monotonically from the substrate surface at Z-axis coordinate equal to zero (z=0) and is greatest within the gate dielectric 112.

The above description of illustrated examples of the present disclosure, including what is described in the Abstract, are not intended to be exhaustive or to be limitation to the precise forms disclosed. For instance, applications of vertical gallium nitride transistors may also be extended to radio frequency (RF) and/or higher frequency applications; and while specific embodiments of vertical gallium nitride transistors are described herein for illustrative purposes, various equivalent modifications are possible without departing from the broader spirit and scope of the present disclosure. Indeed, it is appreciated that the specific example device cross sections are provided for explanation purposes and that other embodiments may also be employed in accordance with the teachings herein. Additionally, specific example voltages, currents, frequencies, power range values, times, etc., are provided for explanation purposes and other values may also be employed in other embodiments and examples in accordance with the teachings herein.

Reference throughout this specification to "one embodiment", "an embodiment", "one example" or "an example" means that a particular feature, structure or characteristic described in connection with the embodiment or example is included in at least one embodiment of the present disclosure. Thus, appearances of the phrases "in one embodiment", "in an embodiment", "one example" or "an example" in various places throughout this specification are not necessarily all referring to the same embodiment or example. Furthermore, the particular features, structures or characteristics may be combined in any suitable combinations and/or subcombinations in one or more embodiments or examples. In addition, it is appreciated that the figures provided herewith are for explanation purposes to persons ordinarily skilled in the art and that the drawings are not necessarily drawn to scale.

The foregoing description may refer to elements or features as being "connected," "electrically connected," and/or "coupled" together. As used herein, unless expressly stated otherwise, "connected" means that one element/feature is directly or indirectly connected to another element/feature, and not necessarily mechanically. Likewise, unless expressly stated otherwise, "coupled" means that one element/feature is directly or indirectly coupled to another element/feature, and not necessarily mechanically.

Moreover, conditional language used herein, such as, among others, "can," "could," "might," "may," "e.g.," "for example," "such as" and the like, unless specifically stated otherwise or otherwise understood within the context as used, is generally intended to convey that certain embodiments include, while other embodiments do not include, certain features, elements and/or states. Thus, such conditional language is not generally intended to imply that features, elements and/or states are in any way required for one or more embodiments or that one or more embodiments necessarily include logic for deciding whether these features, elements and/or states are included or are to be performed in any particular embodiment.

While certain embodiments have been described, these embodiments have been presented by way of example only and are not intended to limit the scope of the disclosure. Indeed, the novel apparatus, methods, and systems described herein may be embodied in a variety of other forms; furthermore, various omissions, substitutions, and changes in the form of the methods and systems described herein may be made without departing from the spirit of the disclosure.

For example, while the disclosed embodiments are presented in a given arrangement, alternative embodiments may perform similar functionalities with different components, materials, and/or semiconductor device layers; and some elements may be deleted, moved, added, subdivided, combined, and/or modified. Each of these elements may be implemented in a variety of different ways. Any suitable combination of the elements and acts of the various embodiments described above can be combined to provide further embodiments. Accordingly, the scope of the present invention is defined only by reference to the appended claims.

Although the claims presented here are in single dependency format for filing at the USPTO, it is to be understood that any claim may depend on any preceding claim of the same type except when that is clearly not technically feasible.

### EMBODIMENTS

Although the present invention is defined in the attached claims, it should be understood that the present invention can also (alternatively) be defined in accordance with the following embodiments:
1. A vertical gallium nitride (GaN) field effect transistor (FET) comprising:
   a GaN substrate;
   a GaN epitaxial (epi) layer grown on the GaN substrate;
   a source layer formed at a surface of the GaN epi layer; and
   a plurality of cylindrical trench gates arranged in a hexagonal array to form a plurality of vertical FET channels.
2. The vertical GaN FET of embodiment 1, wherein each of the plurality of cylindrical trench gates comprise a gate electrode surrounded by a gate dielectric.
3. The vertical GaN FET of embodiment 2, wherein the gate electrode comprises polysilicon.
4. The vertical GaN FET of embodiment 2, wherein the gate dielectric comprises silicon dioxide.
5. The vertical GaN FET of embodiment 1, wherein a threshold voltage of the vertical GaN FET is determined, at least in part, by a trench nearest neighbor distance.
6. The vertical GaN FET of embodiment 5, wherein the trench nearest neighbor distance is between two microns (2um) and zero point one microns (0.1um).
7. The vertical GaN FET of embodiment 6, wherein the vertical GaN FET is an enhancement mode vertical GaN FET.
8. The vertical GaN FET of embodiment 6, wherein the vertical GaN FET is a depletion mode vertical GaN FET.
9. The vertical GaN FET of embodiment 1, wherein the GaN epi layer comprises:
   a drift region; and
   a lightly doped epi region extending from the source layer to the drift region.
10. The vertical GaN FET of embodiment 9, wherein the plurality of cylindrical trench gates extend into the lightly doped epi region and above the drift region by a drift-to-trench-bottom distance.
11. The vertical GaN FET of embodiment 9, wherein the GaN substrate is an n-type GaN substrate having a doping concentration between ten to the eighteenth inverse centimeters cubed (1e18 cm-3) and ten to the twentieth inverse centimeters cubed (1e20 cm-3).
12. The vertical GaN FET of embodiment 9, wherein the drift region comprises a thickness between eight microns (8um) and ten microns (10um), and an n-type doping concentration between nine times ten to the fifteenth inverse centimeters cubed (9e15 cm-3) and two times ten to the sixteenth inverse centimeters cubed (2e16 cm-3).
13. The vertical GaN FET of embodiment 9, wherein the lightly doped epi region comprises a thickness between one micron (1um) and three microns (3um), and an n-type doping concentration between one times ten to the fifteenth inverse centimeters cubed (1e15 cm-3) and three times ten to the fifteenth inverse centimeters cubed (3e15 cm-3).
14. The vertical GaN FET of embodiment 9, wherein the source layer comprises an n-type doping between nine times ten to the seventeenth inverse centimeters cubed (9e17 cm-3) and two times ten to the eighteenth inverse centimeters cubed (2e18 cm-3).
15. The vertical GaN FET of embodiment 1, wherein the source layer comprises a two-dimensional electron gas (2DEG) formed between a surface aluminum gallium nitride (AlGaN) layer and the GaN epi layer.
16. The vertical GaN FET of embodiment 15, wherein the vertical GaN FET is a depletion mode vertical GaN FET.
17. The vertical GaN FET of embodiment 15, wherein the vertical GaN FET is an
   enhancement mode vertical GaN FET.

## Claims

1. A vertical gallium nitride (GaN) field effect transistor (FET) comprising:
a GaN substrate;
a GaN epitaxial (epi) layer grown on the GaN substrate;
a source layer formed at a surface of the GaN epi layer; and
a plurality of cylindrical trench gates arranged in a hexagonal array to form a plurality of vertical FET channels.

2. The vertical GaN FET of claim 1, wherein each of the plurality of cylindrical trench gates comprise a gate electrode surrounded by a gate dielectric.

3. The vertical GaN FET of claim 2, wherein the gate electrode comprises polysilicon.

4. The vertical GaN FET of claim 2, wherein the gate dielectric comprises silicon dioxide.

5. The vertical GaN FET of any preceding claim, wherein a threshold voltage of the vertical GaN FET is determined, at least in part, by a trench nearest neighbor distance.

6. The vertical GaN FET of claim 5, wherein the trench nearest neighbor distance is between two microns (2um) and zero point one microns (0.1um).

7. The vertical GaN FET of claim 6, wherein the vertical GaN FET is an enhancement mode vertical GaN FET or a depletion mode vertical GaN FET.

8. The vertical GaN FET of any preceding claim, wherein the GaN epi layer comprises:
a drift region; and
a lightly doped epi region extending from the source layer to the drift region.

9. The vertical GaN FET of claim 8, wherein the plurality of cylindrical trench gates extend into the lightly doped epi region and above the drift region by a drift-to-trench-bottom distance.

10. The vertical GaN FET of claim 8, wherein the GaN substrate is an n-type GaN substrate having a doping concentration between ten to the eighteenth inverse centimeters cubed (1e18 cm-3) and ten to the twentieth inverse centimeters cubed (1e20 cm-3).

11. The vertical GaN FET of claim 8, wherein the drift region comprises a thickness between eight microns (8um) and ten microns (10um), and an n-type doping concentration between nine times ten to the fifteenth inverse centimeters cubed (9e15 cm-3) and two times ten to the sixteenth inverse centimeters cubed (2e16 cm-3).

12. The vertical GaN FET of claim 8, wherein the lightly doped epi region comprises a thickness between one micron (1um) and three microns (3um), and an n-type doping concentration between one times ten to the fifteenth inverse centimeters cubed (1e15 cm-3) and three times ten to the fifteenth inverse centimeters cubed (3e15 cm-3).

13. The vertical GaN FET of claim 8, wherein the source layer comprises an n-type doping between nine times ten to the seventeenth inverse centimeters cubed (9e17 cm-3) and two times ten to the eighteenth inverse centimeters cubed (2e18 cm-3).

14. The vertical GaN FET of any preceding claim, wherein the source layer comprises a two-dimensional electron gas (2DEG) formed between a surface aluminum gallium nitride (AlGaN) layer and the GaN epi layer.

15. The vertical GaN FET of claim 14, wherein the vertical GaN FET is a depletion mode vertical GaN FET or an enhancement mode vertical GaN FET.
